# EUROPEAN PATENT APPLICATION

(11) **EP 1 978 552 A1**
(43) Date of publication of application: **08.10.2008**
(21) Application number: 06843221.0
(22) Date of filing: 26.12.2006
(51) Int. Cl.: H01L 21/56, B29C 45/27

(54) **METHOD OF ENCAPSULATING ELECTRONIC PART WITH RESIN AND DIE ASSEMBLY AND LEAD FRAME BOTH FOR USE IN THE SAME**

(30) Priority: 23.01.2006 JP 2006013804
(71) Applicant: Towa Corporation, Kyoto 6018105 (JP)
(72) Inventor: HIMENO, Tomonori, Kyoto-shi Kyoto 601-8105 (JP)
(74) Representative: Lipscombe, Martin John
(86) International application number: PCT/JP2006/325837
(87) International publication number: WO 2007/083490

(57) **Abstract**

At a lateral position of a mold cavity counterpart (3) of a non-leaded leadframe (2), a notch (6) used for injecting resin is provided. Molten resin is injected into a mold cavity (34) through the resin injection notch (6) from a resin path (35, 36) provided at the lateral position of the mold cavity (34). Thus, the space between mold cavity counterparts (3) of the non-leaded leadframe (2) arranged in a matrix form can be decreased. Therefore, the number of packages molded using one non-leaded leadframe (2) can be increased. As a result, the productivity of packages enclosing electronic components (4) is improved.

## Description

### TECHNICAL FIELD

The present invention relates to a resin encapsulation molding method for an electronic component for encapsulating, in a resin material, an electronic component (such as IC) attached to a leadframe of non-leaded type such as QFN (Quad Flat Non-leaded Package) type, and to a mold set and a non-leaded leadframe used for the method.

### BACKGROUND ART

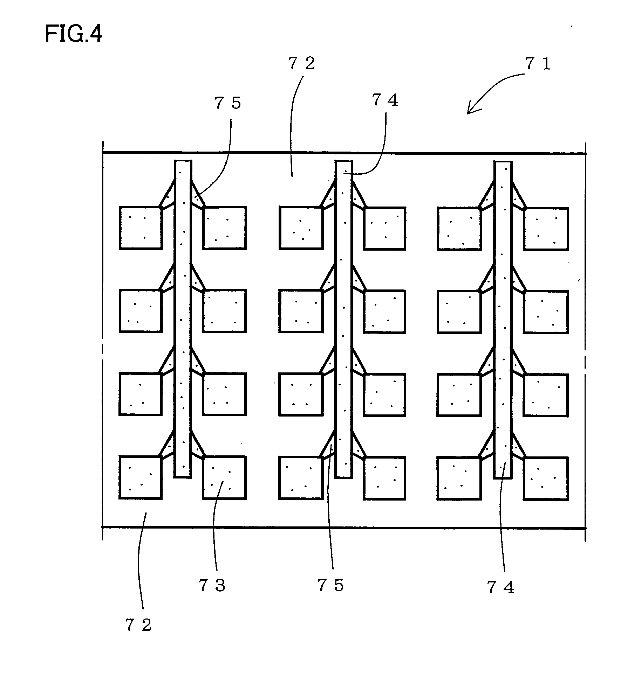

A method has conventionally been used of encapsulating in a resin material an electronic component attached to a leadframe of non-leaded type such as QFN type arranged in a matrix form. The method will be described in the following. Fig. 4 shows a conventional post-molding leadframe which is a leadframe after molded.

The conventional resin encapsulation molding method first prepares a mold set for resin encapsulation molding for an electronic component. The mold set includes an upper mold and a lower mold. Then, at a predetermined position of the lower mold, a pre-molding leadframe which is a leadframe before molded and to which the electronic component is attached is set. The mold set is thereafter closed. Then, molten resin is injected into a mold cavity through a corner gate communicating with a corner of the mold cavity.

After a predetermined period of time required for curing has passed, the mold set is opened. At this time, the electronic component is encapsulated in a package having its shape corresponding to the shape of the mold cavity, namely encapsulated in a molded resin. The package enclosing the electronic component is a post-molding leadframe 71, namely a molded product as shown in Fig. 4.

Further, as shown in Fig. 4, post-molding leadframe 71 includes a leadframe portion 72, a package 73, a runner resin 74 and a corner gate resin 75. Packages 73 are arranged in a matrix form on leadframe portion 72.

At post-molding leadframe 71, runner resin 74 is disposed between two columns of packages 73 arranged in the width direction of leadframe portion 72, namely in the top-bottom direction as seen in Fig. 4. Runner resin 74 and packages 73 arranged on both sides of the runner resin are each connected via corner gate resin 75.

After this, post-molding leadframe 71 is cut along the outer periphery of package 73. In this way, non-leaded package 73 in the state where the lead portion is attached to package 73 can be obtained.

In the case as shown in Fig. 4 where the non-leaded leadframe used for forming a plurality of packages 73 arranged in a matrix form is used, molten resin is usually injected into the mold cavity through a mold gate from a corner of the mold cavity where there is no lead portion. This is called corner gate method.
Patent Document 1: Japanese Patent Laying-Open No. 05-315514

### DISCLOSURE OF THE INVENTION

### PROBLEMS TO BE SOLVED BY THE INVENTION

As shown in Fig. 4, runner resin 74 and each of a plurality of packages 73 are connected via corner gate resin 75. Therefore, corner gate resin 75 is inevitably formed between packages 73. Thus, it is considerably difficult to reduce the space between packages 73 in the direction in which runner resin 74 extends.

The number of packages 73 obtained from one leadframe portion 72 cannot be increased. Thus, the manufacturing efficiency of packages 73 is decreased.

The present invention has been made in view of the above-described problems. An object of the invention is to provide a resin encapsulation molding method for an electronic component with which the manufacturing efficiency for products can be improved, and a mold set and a leadframe used for the method.

### MEANS FOR SOLVING THE PROBLEMS

According to a resin encapsulation molding method for an electronic component of the present invention, an electronic component attached to a pre-molding leadframe having a notch is inserted into a mold cavity. Then, molten resin is injected into the mold cavity through the notch from a resin path located at a side of the mold cavity. After this, a non-leaded package enclosing the electronic component is formed by converting the molten resin into cured resin.

According to a resin encapsulation molding method for an electronic component of the present invention, an electronic component attached to a pre-molding leadframe having a notch is inserted into a mold cavity. Then, molten resin is injected into the mold cavity through the notch from a resin path located at a side of the mold cavity. After this, a post-molding leadframe is formed that has a package enclosing the electronic component by converting the molten resin into cured resin. Then, a non-leaded package is formed from the post-molding leadframe by ejecting the cured resin in the resin path to cut the cured resin and the package at the notch.

A mold set for resin encapsulation molding for an electronic component of the present invention includes: a mold cavity into which an electronic component is inserted that is attached to a non-leaded pre-molding leadframe having a notch at its side; and a resin path for injecting molten resin into the mold cavity. In a state where the mold set is closed, the mold cavity and the resin path communicate with each other via the notch.

A pre-molding leadframe of the present invention is a non-leaded leadframe for encapsulating in a resin an electronic component attached in a mold cavity counterpart. A notch for injecting resin is provided at a side position of the mold cavity counterpart.

### EFFECTS OF THE INVENTION

According to the present invention, the manufacturing efficiency for products can be improved.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a top view showing a post-molding leadframe where a non-leaded leadframe arranged in a matrix form is encapsulated in a resin in an embodiment.
Fig. 2 is an enlarged view of the post-molding leadframe as shown in Fig. 1.
Fig. 3 is a longitudinal cross-sectional view of a mold set for resin encapsulation molding for an electronic component in an embodiment.
Fig. 4 is a plan view of a conventional post-molding leadframe.

### DESCRIPTION OF THE REFERENCE SIGNS

1 post-molding leadframe, 2 pre-molding leadframe or leadframe portion, 3 mold cavity counterpart, 4 electronic component, 5, 5a lead portion, 6 notch, 7 ejection hole, 8 cut hole, 9 hang pin, 10 die pad portion, 21 package, 22 runner resin, 23 gate resin, 24 dummy resin, 25 plate-like gate resin, 31 mold set, 32 upper mold, 33 lower mold, 34 mold cavity, 35 mold runner, 36 mold gate, 37 dummy mold cavity, 38 depressed portion, 39 arrow indicating flow path of molten resin, 40 main mold runner

### BEST MODES FOR CARRYING OUT THE INVENTION

With reference to the drawings, a resin encapsulation molding method for an electronic component as well as a mold set and a non-leaded leadframe used for the method in an embodiment of the present invention will be hereinafter described.

### Structure of Pre-Molding Leadframe

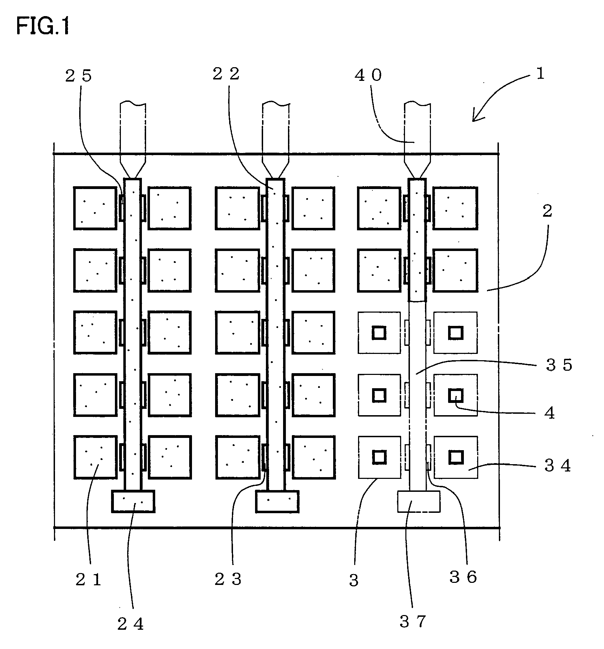

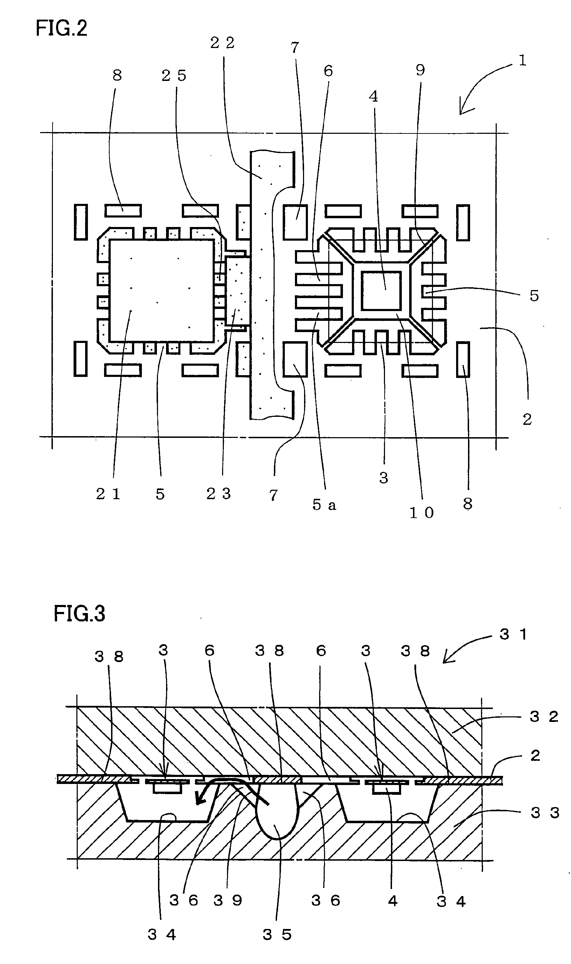

Referring to Figs. 1 and 2, a description will be first given of a structure of pre-molding leadframe 2 or leadframe portion 2 of post-molding leadframe 1 of the present invention. In Figs. 1 and 2, components relevant to a mold set 31 used for resin encapsulation molding for an electronic component as shown in Fig. 3 are indicated at post-molding leadframe 1 by chain double-dashed lines.

Pre-molding leadframe 2 is provided with a mold cavity counterpart 3 (indicated by a chain double-dashed line) corresponding to an opening of a mold cavity 34 provided in mold set 31 shown in Fig. 3. Further, with this pre-molding leadframe 2, an electronic component 4 such as an IC (Integration Circuit) is attached to a die pad portion 10 in mold cavity counterpart 3 and the electronic component in this state is encapsulated in a molded resin serving as a package 21 having its shape corresponding to the shape of mold cavity 34 (see Figs. 1 and 2).

Further, at pre-molding leadframe 2, mold cavity counterparts 3 are arranged in a matrix form along the width direction and the longitudinal direction of the leadframe. At mold cavity counterpart 3, package 21 is formed.

Here, regarding leadframe portion 2 of post-molding leadframe 1 shown in Figs. 1 and 2, the width direction is the top-bottom direction as seen in the drawings and the longitudinal direction is the right-left direction as seen in the drawings.

Further, as shown in Fig. 1, between mold cavity counterparts 3 (corresponding to packages 21 and mold cavities 34), a mold runner 35 (corresponding to a runner resin 22 shown in Figs. 1 and 2) shown in Fig. 3 is provided to extend in the column direction (top-bottom direction as seen in Figs. 1 and 2).

Here, as described hereinlater, regarding mold set 31 in Fig. 3, mold cavity 34 and a short mold gate 36 that are provided at either side of mold runner 35 are disposed with a predetermined distance therebetween. Short mold gate 36 corresponds to a gate resin 23 shown in Figs. 1 and 2. Mold cavity 34 corresponds to mold cavity counterpart 3.

Further, as shown in Fig. 2, at matrix-form pre-molding leadframe 2, a predetermined number of lead portions 5 are arranged side by side along the four sides of mold cavity counterpart 3. Furthermore, between counter cavity counterparts 3, runner resin 22 is provided. Lead portions 5a are provided along mold cavity counterpart 3 in parallel with runner resin 22 and in the vicinity of runner resin 22, and lead portions 5a are longer than lead portions 5 provided along other sides of mold cavity counterpart 3. Between these lead portions 5a, notches 6 serving as a predetermined number of holes for injecting resin are provided.

Specifically, as described hereinlater, as mold set 31 shown in Fig. 3 is closed, mold cavity 34 (corresponding to mold cavity counterpart 3) and mold gate 36 communicate with each other via notch 6. Therefore, as described hereinlater, molten resin is passed through mold runner 35 and mold gate 36 and thereafter injected through notch 6 (plate-like gate) of pre-molding leadframe 2 into mold cavity 34.

Here, Fig. 2 shows an ejection hole 7 for ejecting runner resin 22, a cut hole 8 for cutting leadframe portion 2, and a hang pin 9 for hanging die pad portion 10. At leadframe portion 2, a positioning hole in circular or rectangular shape for example, a slit for preventing leadframe portion 2 from flapping at an increased temperature, and the like are not shown in Fig. 2.

Further, at post-molding leadframe 1 shown in Fig. 1, a dummy resin 24 is connected to runner resin 22. A dummy mold cavity 37 communicates with mold runner 35 so as to allow dummy resin 24 to be molded.

Furthermore, at post-molding leadframe 1, runner resin 22 and each of packages 21 arranged on both sides of the runner resin are connected through gate resin 23 and a plate-like resin 25 in the shape of a thin plate that is cured in notch 6.

In the present embodiment, one unit is composed of two columns of packages 21 arranged in the width direction of leadframe portion 2, one runner resin 22 between these two columns of packages 21 and their relevant components.

### Mold Structure

Referring then to Fig. 3, mold set 31 for an electronic component of the present invention will be described.

As shown in Fig. 3, mold set 31 includes an upper mold 32 with its position fixed and a movable lower mold 33 disposed opposite to upper mold 32. At a predetermined position of lower mold 33, a depressed portion 38 at which pre-molding leadframe 2 is set is provided.

Further, at predetermined positions of lower mold 33, a predetermined number of mold cavities 34 are provided in an arrangement corresponding to the matrix arrangement of a predetermined number of mold cavity counterparts 3 of pre-molding leadframe 2. Mold cavity counterpart 3 corresponds to package 21 of post-molding leadframe 1.

Furthermore, between the columns of mold cavities 34 in the width direction of pre-molding leadframe 2, mold runner 35 is provided. Mold runner 35 is used for directing molten resin in the width direction of pre-molding leadframe 2.

Moreover, at a surface of lower mold 33, short mold gate 36 is provided at mold runner 35-side of mold cavity 34, namely the lateral side of mold cavity 34. Short mold gate 36 communicates with mold runner 35 and is spaced apart from mold cavity 34.

In the state where mold set 31 is closed, mold gate 36 and mold cavity 34 provided at either side of mold runner 35 communicate with each other via resin-injection cut hole 8 of pre-molding leadframe 2 set in depressed portion 38.

Therefore, in mold set 31, the molten resin is supplied from mold runner 35 successively to mold gate 36 and notch 6 and injected from the lateral position of mold cavity 34 into mold cavity 34. This is called side gate method. In Fig. 3, the flow path of the molten resin is indicated by an arrow 39.

For a resin encapsulation molding method for an electronic component in the present embodiment, notch 6 for injecting resin is provided in pre-molding leadframe 2, and molten resin is injected into mold cavity 34 via notch 6 and from the lateral position of mold cavity 34. Therefore, as compared with a method of injecting molten resin from the corner gate into the mold cavity, which is included in the conventional resin encapsulation molding method for an electronic component, the space between packages 21 in the width direction of pre-molding leadframe 2 can be decreased.

Therefore, as compared with the conventional mold set, the number of packages 21 (products) that can be obtained using one pre-molding leadframe 2 can be increased. As a result, the productivity of electronic components is improved.

Mold set 31 is provided with a lower pot for supplying a resin material, a plunger for applying pressure to the resin and an upper cull for distributing resin, while these components are not shown. The pot (cull) and mold runner 35 communicate with each other through a main mold runner 40.

### Resin Encapsulation Molding Method for Electronic Component

A description will now be given of a resin encapsulation molding method for an electronic component attached to pre-molding leadframe 2.

As shown in Fig. 3, pre-molding leadframe 2 arranged in a matrix form is first set at depressed portion 38 of lower mold 33 in the state where electronic component 4 faces downward. After this, upper mold 32 and lower mold 33 are closed. Accordingly, mold cavity 34 and mold gate 36 communicate with each other through resin injection notch 6 of pre-molding leadframe 2.

Then, resin material that is heated to be melted in the pot is pressurized by the plunger, so that the resin material passes through the cull and main mold runner 40. The molten resin is further passed through mold runner 35 and mold gate 36, and is thereafter injected from notch 6 into mold cavity 34.

In this way, in mold cavity 34, in package 21 having its shape corresponding to the shape of mold cavity 34, electronic component 4 attached to pre-molding leadframe 2 is encapsulated. As a result, post-molding leadframe 1 encapsulating electronic component 4, namely a molded product is obtained.

At this time, in mold runner 35 and mold gate 36, cured resin that is unnecessary for the product is formed. Further, in notch 6, plate-like gate resin 25 in the shape of a thin plate that is unnecessary for the product is also formed.

After a predetermined period of time required for curing has passed, upper mold 32 and lower mold 33 are opened. Package 21 is thus removed from mold cavity 34.

According to the above-described method, notch 6 used for injecting resin is provided to pre-molding leadframe 2. Molten resin can be injected from the lateral position of mold cavity 34 into mold cavity 34. As compared with the conventional resin encapsulation molding method for an electronic component that forms corner gate resin 75, the space between packages 21 in the width direction of pre-molding leadframe 2 can be decreased.

In other words, according to the resin encapsulation molding method for an electronic component in the present embodiment, the number of packages 21 arranged in a matrix form on pre-molding leadframe 2 can be increased as compared with the conventional resin encapsulation molding method for an electronic component. Therefore, the productivity of electronic components can be improved.

### Gate Cutting

Then, a description will be given of a method of cutting, from post-molding leadframe 1, cured resin which is unnecessary for products and a leadframe portion. This method removes resin in main mold runner 40 and runner resin 22. Post-molding leadframe 1 is thus formed.

An ejection pin is caused to protrude from the rear side of post-molding leadframe 1 through ejection hole 7. Thus, the ejection pin forces runner resin 22 including dummy resin 24 to be detached.

At this time, plate-like gate resin 25 in the shape of a thin plate that is cured in notch 6 is forced to be detached together with runner resin 22 including gate resin 23. Therefore, package 21 and plate-like gate resin 25 are cut off from each other at a low-strength and thin-plate portion connecting them. Accordingly, from package 21, runner resin 22 including plate-like gate resin 25 and gate resin 23 can be cut off.

Thus, the conventional step of cutting a gate using a gate cutter can be eliminated. As a result, the productivity for products can be improved.

Then, the peripheral portion of the package on post-molding leadframe 1 is cut away to obtain package 21 (non-leaded product).

In the present embodiment, the four corners of package 21 are first cut and then the four sides of package 21 are cut. Accordingly, package 21 (non-leaded product) is obtained from post-molding leadframe 1.

The non-leaded product is formed in the state where lead portion 5 is attached to package 21.

In the present embodiment, notch 6 which is used for injecting resin is provided at pre-molding leadframe 2. Thus, the space between mold cavity counterparts 3 of pre-molding leadframe 2, namely the space between packages 21 of post-molding leadframe 1 can be decreased. As a result, the number of packages 21 obtained from one pre-molding leadframe 2 can be increased. Namely, the resin encapsulation molding method for an electronic component in the present invention can form mold cavity counterparts 3, namely packages 21, in a matrix form with a higher degree of integration. Therefore, the productivity for products including non-leaded packages 21 can be improved.

While the present embodiment employs mold set 31 provided with mold gate 36, a mold set provided with mold runner 35 only may be employed. Regarding this mold set, mold cavity 34 and mold runner 35 directly communicate with each other through notch 6 of pre-molding leadframe 2. Both of mold gate 36 and mold runner 35 serve as a resin path provided in mold set 31 for conveying resin.

In the present embodiment, the resin in the path including runner resin 22 and plate-like gate resin 25 cured in the resin path including mold gate 36 and mold runner 35 provided at a lateral position of mold cavity 34 are forced to be detached. Thus, plate-like gate resin 25 connecting package 21 and notch 6 is cut away. As a result, the resin in the path including plate-like gate resin 25 is cut away from package 21.

Accordingly, the space between packages 21 arranged in a matrix form in the width direction can be decreased. Therefore, the number of packages 21 obtained from one pre-molding leadframe 2 can be increased. By encapsulating in resin non-leaded pre-molding leadframe 2 arranged in a matrix form, the productivity can be improved of non-leaded packages 21, namely the molded products encapsulating the electronic components that can be manufactured using one pre-molding leadframe 2.

While the present embodiment employs mold set 31 having mold runner 35 formed to extend in the width direction of pre-molding leadframe 2, any mold set having mold runner 35 formed to extend in the longitudinal direction of pre-molding leadframe 2, namely the right-left direction, may be employed.

Further, while the present embodiment shows a strip-shaped leadframe as an example, the present invention is applicable to a leadframe having a long lead.

Although the present invention has been described and illustrated in detail, it is clearly understood that the same is by way of illustration and example only and is not to be taken by way of limitation, the scope of the present invention being interpreted by the terms of the appended claims.

## Claims

1. A resin encapsulation molding method for an electronic component, comprising the steps of:
inserting into a mold cavity (34) an electronic component (4) attached to a pre-molding leadframe (2) having a notch (6) at its lateral side;
injecting molten resin into said mold cavity (34) through said notch (6) from a resin path (35, 36) located at a lateral side of said mold cavity (34); and
forming a non-leaded package (21) enclosing said electronic component (4) by converting said molten resin into cured resin.

2. A resin encapsulation molding method for an electronic component, comprising the steps of:
inserting into a mold cavity (34) an electronic component (4) attached to a pre-molding leadframe (2) having a notch (6) at its lateral side;
injecting molten resin into said mold cavity (34) through said notch (6) from a resin path (35, 36) located at a lateral side of said mold cavity (34);
forming a post-molding leadframe (1) having a package (21) enclosing said electronic component (4) by converting said molten resin into cured resin; and
forming a non-leaded package (21) from said post-molding leadframe (1) by ejecting said cured resin in said resin path (25, 26) to cut said cured resin and said package (21) at said notch (6).

3. A mold set for resin encapsulation molding for an electronic component, comprising:
a mold cavity (34) into which an electronic component (4) is inserted that is attached to a non-leaded pre-molding leadframe (2) having a notch (6) at its lateral side; and
a resin path (35, 36) for injecting molten resin into said mold cavity (34),
in a state where said mold set (32, 33) is closed, said mold cavity (34) and said resin path (35, 36) communicating with each other via said notch (6).

4. A non-leaded pre-molding leadframe (2) for encapsulating in resin an electronic component (4) attached in a mold cavity counterpart (3), wherein
a notch (6) for injecting resin is provided at a lateral position of said mold cavity counterpart (3).

## Amended claims

### Amended claims under Art. 19.1 PCT

**1.** (amended) A resin encapsulation molding method for an electronic component, comprising the steps of:
inserting into a first mold cavity (34) and a second mold cavity (34) respectively a first electronic component (4) and a second electronic component (4) attached to a pre-molding leadframe (2) having a first notch (6) and a second notch (6);
injecting molten resin into said first mold cavity (34) through said first notch (6) and injecting molten resin into said second mold cavity (34) through said second notch (6), from a resin path (35, 36) located between said first mold cavity (34) and said second mold cavity (34); and
forming a first non-leaded package (21) enclosing said first electronic component (4) and a second non-leaded package (21) enclosing said second electronic component (4) by converting said molten resin into cured resin.

**2.** (amended) A resin encapsulation molding method for an electronic component, comprising the steps of:
inserting into a first mold cavity (34) and a second mold cavity (34) respectively a first electronic component (4) and a second electronic component (4) attached to a pre-molding leadframe (2) having a first notch (6) and a second notch (6);
injecting molten resin into said first mold cavity (34) through said first notch (6) and injecting molten resin into said second mold cavity (34) through said second notch (6), from a resin path (35, 36) located between said first mold cavity (34) and said second mold cavity (34);
forming a post-molding leadframe (1) having a first non-leaded package (21) enclosing said first electronic component (4) and a second non-leaded package (21) enclosing said second electronic component (4) by converting said molten resin into cured resin; and
separating said first non-leaded package (21) and said second non-leaded package (21) from said cured resin corresponding to said resin path (35, 36).

**3.** A mold set for resin encapsulation molding for an electronic component, comprising:
a first mold cavity (34) and a second mold cavity (34) into which a first electronic component (4) and a second electronic component (4) are respectively insertable that are attached to a non-leaded pre-molding leadframe (2) having a first notch (6) and a second notch (6); and
a resin path (35, 36) extending between said first mold cavity (34) and said second mold cavity (34) such that molten resin is injectable into said first mold cavity (34) and said second mold cavity (34),
said first mold cavity (34) and said resin path (35, 36) communicable with each other via said first notch (6) and said second mold cavity (34) and said resin path (35, 36) communicable with each other via said second notch (6).

**4.** (amended) A non-leaded pre-molding leadframe (2) for encapsulating in resin a first electronic component (4) attached to a first mold cavity counterpart (3) and a second electronic component (4) attached to a second mold cavity counterpart (3), wherein
said first electronic component (4) and said second electronic component (4) are insertable into a first mold cavity (34) and a second mold cavity (34) respectively,
said pre-molding leadframe (2) has a first notch (6) for injecting resin, in a passage extending from a resin path (35, 36) located between said first mold cavity (34) and said second mold cavity (34) to said first mold cavity (34), and has a second notch (6) for injecting resin, in a passage extending from said resin path (35, 36) to said second mold cavity (34), and
molten resin is injectable from said resin path (35, 36) into said first mold cavity (34) through said first notch (6) and injectable therefrom into said second mold cavity (34) through said second notch (6).
